Europäisches Patentamt

European Patent Office

Office européen des brevets

(19)

(11) Veröffentlichungsnummer: **0 158 066**

**A1**

(12) **EUROPÄISCHE PATENTANMELDUNG**

(21) Anmeldenummer: **85101973.7**

(22) Anmeldetag: **22.02.85**

(51) Int. Cl.⁴: **G 01 P 3/486**

(30) Priorität: **01.03.84 DE 3407590**

(43) Veröffentlichungstag der Anmeldung:
**16.10.85 Patentblatt 85/42**

(84) Benannte Vertragsstaaten:
**CH DE FR GB LI SE**

(71) Anmelder: **Kienzle Apparate GmbH**
**Heinrich-Hertz-Strasse**
**D-7730 Villingen-Schwenningen(DE)**

(72) Erfinder: **Daiger, Robert**
**Warenburgstrasse 31**
**D-7730 Villingen-Schwenningen(DE)**

(72) Erfinder: **Hoeren, Kurt**
**Bad Dürrheimer Strasse 19**
**D-7734 Brigachtal(DE)**

(72) Erfinder: **Hummel, Dietmar**
**Röntgen-Strasse 45**
**D-7730 Villingen-Schwenningen(DE)**

(54) **Fotoelektrischer Impulsgeber.**

(57) Gegenstand ist ein fotoelektrischer Impulsgeber zur Umsetzung digitaler Meßwerte in Form einer Drehbewegung in Impulse für die Verwendung in eichfähigen Geräten, wobei die Impulse durch die Bewegung einer Schlitzscheibe im Strahlengang einer Lichtschranke erzeugt werden.

Zur Erzeugung einer fehlerfreien Impulsfolge sind in fester Anordnung auf einer Leiterplatte (7) vier Lichtschranken (3, 4, 5, 6) vorgeschen, die auf einem Kreisbogen (9) mit dem mittleren Radius einer Modulatorzone (15) der Schlitzscheibe (8) in gleichen Drehwinkelabständen (α) angeordnet sind. Um die kritischen Übergangsphasen im Hell- Dunkel-Bereich zu beherrschen sowie Fehlimpulse durch Toleranzen im elektrischen und mechanischen Bereich auszuschalten, ist die Leiterplatte (7) mit den vier Lichtschranken (3, 4, 5, 6) durch eine Parallelverschiebung und Verdrehung der Lage bezogen auf die Modulatorzone (15) einstellbar, dergestalt daß durch die Veränderbarkeit der Lage der Lichtschranken (3, 4, 5, 6) eine Ableichung eines Impuls-Pause-Verhältnisses sowie ein gegenseitiger Versatz der beiden Impulsfolgen (29, 30) einstellbar ist

Neben der Anwendung in allen Bereichender Umsetzung und Übertragung von Meßwerten in digital auswertbarer Impulsform ist aufgrund der druckfesten Kapselung der elektrischen Schaltung (24) im Gehäuse (1, 2) eine Verwendung in exgefährdeten Bereichen, beispielsweise in Zapfsäulen, vorgesehen.

FIG. 1

## 1 Fotoelektrischer Impulsgeber

Die Erfindung bezieht sich auf einen fotoelektrischen Impulsgeber zur Umsetzung digitaler Meßwerte in Form einer Drehbewegung in Impulse für die Verwendung in eichfähigen Geräten, wobei die Impulse durch die Bewegung einer Schlitzscheibe im Strahlengang einer Lichtschranke erzeugt werden.

Bei bekannten Impulsgebern der bezeichneten Art verwendet man für eine Lichtschranke auf der Senderseite eine modulierte Strahlenquelle, meist in Form einer Ga-As-Lumineszenzdiode, und auf der Empfängerseite ein Fotobauelement mit den für besondere Anwendungsfälle spezifizierten Eigenschaften. Die Modulation erfolgt auf einfache Weise mechanisch durch eine Loch- oder Schlitzscheibe. Die Impulse werden dadurch erzeugt, daß die auf einer drehbar gelagerten Welle befestigte Schlitzscheibe die Lichtstrahlen auf dem Wege von der Strahlenquelle zu einem entsprechend angeordneten Lichtempfänger alternierend unterbricht und wieder freigibt. Die Anzahl der Impulse je Umdrehung richtet sich nach der Anzahl der auf dem Umfang angeordneten Zähne.

Auf der Empfängerseite sind es Fotobauelemente, die je nach Anwendungsfall im Hinblick auf die erforderliche Empfindlichkeit und Bauform ausgewählt werden. In einer verbreiteten Ausführungsform sind es Silizium-Fototransistoren, die in einer Kombination von zwei oder mehr Transistoren zu einem sog. Fotodarlington zusammengeschaltet sind. Diese Maßnahme dient der Verstärkung des Fotostromes, verbessert dadurch die Empfindlichkeit des Fototransistors und erhöht jedoch auch die Ansprechzeit entsprechend.

Um eine möglichst gleichbleibende Spezifikation bei Lichtschranken zu erzielen, werden bei bekannten Lichtschranken die Lichtstrahlenquelle und der fotoelektrische Empfänger in einer möglichst optimalen Funktionslage zueinander angeordnet und zur Beibehaltung dieser Position in einem Gießharzblock eingebettet. Derartige Lichtschranken sind als sog. Gabellichtschranken bekannt geworden aufgrund der gabelförmigen Anordnung der Lichtquelle zum Lichtempfänger, zwischen welchen beispielsweise eine Schlitzscheibe als Modulator bewegt wird. Auch diese lagemäßig feste Zuordnung der Bauelemente zueinander vermochte nicht die Differenzen in der unterschiedlichen Wirkungsweise zu beseitigen. Die Ursache ist darin zu suchen, daß die einzelnen Bauelemente, wie Lichtquelle und Lichtempfänger, nicht von gleichbleibender technischer Beschaffenheit sind, so daß trotz exakter mechanischer Anordnung in Abhängigkeit der Toleranzen in der technologischen Beschaffenheit unvermeidlich unterschiedliche Schaltcharakteristiken entstehen. Nur nach dem Durchlauf einmal festgelegter Testbedingungen über bestimmte Meßreihen lassen sich die Bereiche einer auswertbaren Signalbildung ermitteln und auf Datenblättern den einzelnen Lichtschranken beigeben.

Aus der US-PS 2 656 106 ist eine lichtelektrische Positions-Anzeigeeinrichtung für eine in beide Richtungen drehbare Welle angegeben. Sie besteht aus einer Schlitzscheibe und zwei im Bereich der Schlitze in einem bestimmten Drehwinkelabstand angeordneten Lichtschranken. Durch Rotation der Schlitzscheibe werden aufgrund der Unterbrechungen des Lichtstrahlenganges in den fotoelektrischen Empfängerteilen voneinander getrennte Impulsfolgen in Abhängigkeit der Anzahl der auf dem Umfang angeordneten Schlitze erzeugt. Die Anordnung zweier Lichtschranken dient hierbei dazu, anhand der beiden Impulsfolgen unter anderem die Drehrichtung zu ermitteln. Die eine Zahnlücke oder einen Schlitz der Schlitzscheibe markierenden Flanken sind in exakt radialer Richtung ausgebildet. Das bedeutet bei der Bewegung der Zahnflankenlinie durch den Lichtstrahlengang steht für eine Modulationsphase nur der kürzestmögliche Winkelweg zur Verfügung.

Q158066

Dieser kürzestmögliche Winkelweg reicht nicht aus, eine Schalthysterese der fotoelektrischen Lichtschranke und zusätzlich eine evtl. Rücklaufsperrtoleranz der Welle zu überdecken. Eine Verschiebung der Impulsflanken jedoch ist nicht möglich. Als Folge hiervon entstehen im unmittelbaren Bereich der Schaltzone Fehlimpulse, die einen Zählvorgang verfälschen. Von der Lichtschranke einmal gegebene Fehlerimpulse sind nicht oder nur sehr schwer und mit erheblichem Aufwand an elektronischen Schaltungsmitteln zu identifizieren.

In der US-PS 3 436 655 ist eine Wellen-Drehzahlmeßeinrichtung angegeben, die insbesondere für die Messung der Drehzahl pro Zeiteinheit für sehr langsam laufende Wellen ausgebildet ist. Eine genaue Messung einer langsamen Drehbewegung ist normalerweise schwierig, weil die drehende Welle zittert oder in Bewegungsrichtung flattert. Diese Erscheinung zu eliminieren ist fast unmöglich, und deshalb versucht man, die Auswirkung derselben zu beseitigen. Hierzu sind zwei Lichtschranken in Drehwinkelrichtung einer Schlitzscheibe so versetzt angeordnet, daß niemals gleichzeitig die erste und die zweite Fotozelle in einen Lichtstrahlengang gelangen. Die beiden Fotozellen sind mit einem RS-Flip-Flop verbunden, durch welches dann Flattererscheinungen in der Umschaltphase eliminiert werden. Die Schlitzscheibe weist enge, radial verlaufende Schlitze auf, zwischen welchen relativ breite, lichtundurchlässige Zonen angeordnet sind. Die Modulatorzone für die Lichtschranke ist damit ebenfalls auf einen minimalen Drehwinkel beschränkt, der für die Schalthysterese der Lichtschranke keine Korrektur zuläßt. Die Lage der Flanken des Impulszuges am Ausgang des Flip-Flops ist nicht veränderbar, und auch in bezug auf das Impuls-Pause-Verhältnis der Impulsserie am Ausgang des Flip-Flop ist keine Korrektur möglich.

Bei dem durch die DE-OS 27 26 242 bekannt gewordenen Rotationsimpulsgeber ist der Versuch gemacht, durch eine besondere Anordnung und Ausbildung der Schlitzform der Modulatorscheibe eine Verbesserung herbeizuführen. Die koaxial aus zwei gleichartigen Schlitzscheiben zusammensetzbare und gegeneinander verdrehbeweglich auf ein bestimmtes Zahn-Lücken-Verhältnis fest einstellbare Schlitzscheibenblende und die durch eine von der radialen Anordnung abweichende und zur tangentialen Richtung gleichermaßen geneigte Anordnung der Zähne und Lücken erlauben jedoch lediglich eine lineare Veränderung des Zahn-Lücken-Verhältnisses einzustellen, was sich in einem entsprechenden Impuls-Pause-Verhältnis des Impulszuges ausdrückt. Es ist jedoch damit nicht möglich, die Anstiegsflanken und Abfallflanken gegeneinander zu verschieben und den beiden Impulsfolgen unterschiedliche Impuls-Pausen-Verhältnisse zuzuteilen.

Aufgabe der Erfindung ist es, bei einem Impulsgeber der angezeigten Art mit einfachen Mitteln eine mechanische Justierfähigkeit einzuführen, wodurch das Impuls-Pause-Verhältnis der Impulsfolge variabel und zusätzlich ein Versatz der beiden Impulsfolgen einstellbar ist und damit system- und bauteilebedingte Schalteffekte weitgehend ausgeschaltet und die Schalthysterese der Lichtschranke, bezogen auf eine Rücklaufsperre, an der Modulatorscheibe erweiterungsfähig sind. Darüber hinaus ist die Schaltungsanordnung in einer kompakten Bauform auszubilden als Voraussetzung für den Einbau in eine druckfeste Kapselung.

Die Lösung der Aufgabe ist dadurch gekennzeichnet, daß in fester Anordnung auf einer Leiterplatte vier Lichtschranken vorgesehen und die Lichtschranken auf einem Kreisbogen mit dem mittleren Radius einer Modulatorzone der Schlitzscheibe in gleichen Drehwinkelabständen angeordnet sind, daß die Leiterplatte mit den vier Lichtschranken durch eine Parallelverschiebung und Verdrehung der Lage, bezogen auf die Modulatorzone, einstellbar ist dergestalt, daß durch die Veränderbarkeit der Lage der Lichtschranken eine Abgleichung eines Impuls-Pause-Verhältnisses sowie ein gegenseitiger Versatz der beiden Impulsfolgen einstellbar ist.

Ausgehend von einem bestimmten gleichen Winkelabstand der vier Lichtschranken zueinander ergeben sich in Abhängigkeit der Drehgeschwindigkeit der Schlitzscheibe vier nacheinander zeitlich verzögerte Schaltimpulse. Werden in der Ausgangseinstellung der Lichtschranken die Schaltimpulse an die Eingänge der beiden Flip-Flops der angegebenen Schaltung gelegt, so entstehen an den Ausgängen der Flip-Flops zwei voneinander um 90° versetzte Rechtecksignale. Aufgrund der festen Anordnung der vier Lichtschranken auf der Leiterplatte und der variablen Einstellung der Leiterplatte bezogen auf die Modulatorzone lassen sich durch Verschieben oder Drehen der Leiterplatte andere Winkelpositionen der Lichtschranken zueinander einstellen. Dadurch verändern sich gleichzeitig die Wegabstände zwischen den einzelnen Schaltimpulsen. In der Folge führt dies zu einer entsprechenden Verschiebung der Ausgangssignale an den Flip-Flops. Auf einfachste Weise läßt sich aufgrund der mechanisch einjustierbaren Leiterplatte genau das Impuls-Pause-Verhältnis und der Versatz der Rechtecksignale der ersten Impulsfolge zu den Rechtecksignalen der zweiten Impulsfolge abgleichen.

Ein Ausführungsbeispiel der Erfindung ist nachstehend beschrieben und in den Zeichnungen dargestellt. Es zeigt

FIG. 1 eine Ansicht eines kompletten Impulsgebers bei abgenommenem Gehäusedeckel,

FIG. 2 ein Schnittbild durch den Impulsgeber gemäß FIG. 1,

FIG. 3 eine schematisierte Darstellung der Anordnung der vier Lichtschranken im Bereich der Modulatorzone der Schlitzscheibe sowie die entsprechende Schaltimpulsfolge der vier Lichtschranken einschl. der dadurch entstehenden Rechtecksignale am Ausgang der Flip-Flops,

FIG. 4 eine Anordnung nach FIG. 3 zuzüglich der Phasenlage der Schaltimpulse und entsprechend der Rechtecksignale am Ausgang der beiden Flip-Flops aufgrund der Verdrehung der Leiterplatte mit den Lichtschranken als ein Beispiel der Abgleichmöglichkeit,

FIG. 5 eine Schaltungsanordnung zur Umformung der Schaltimpulse der vier Lichtschranken in definierte Rechtecksignale.

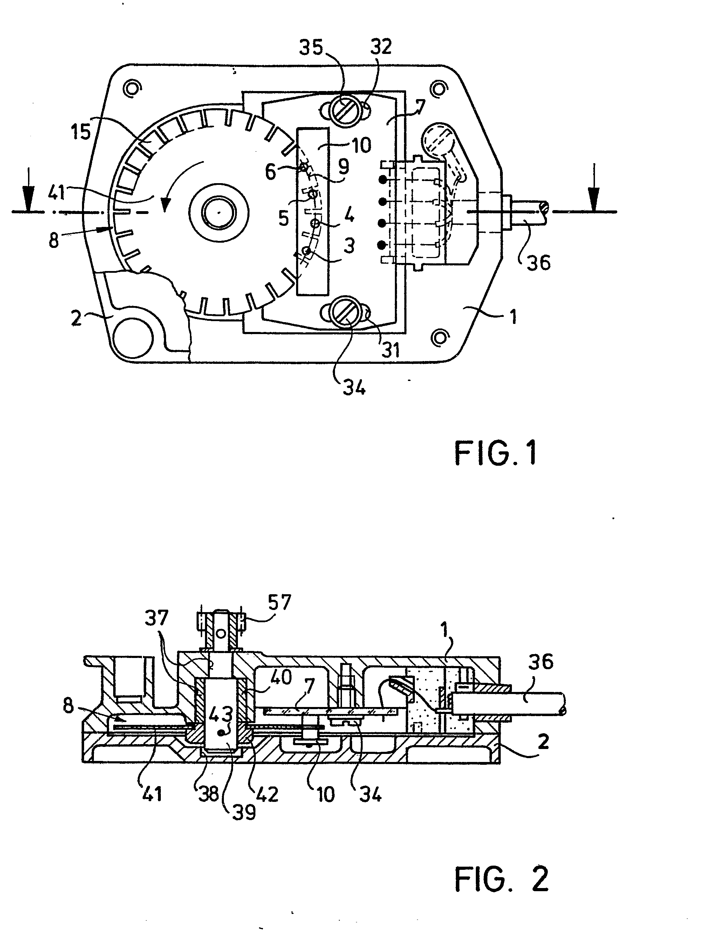

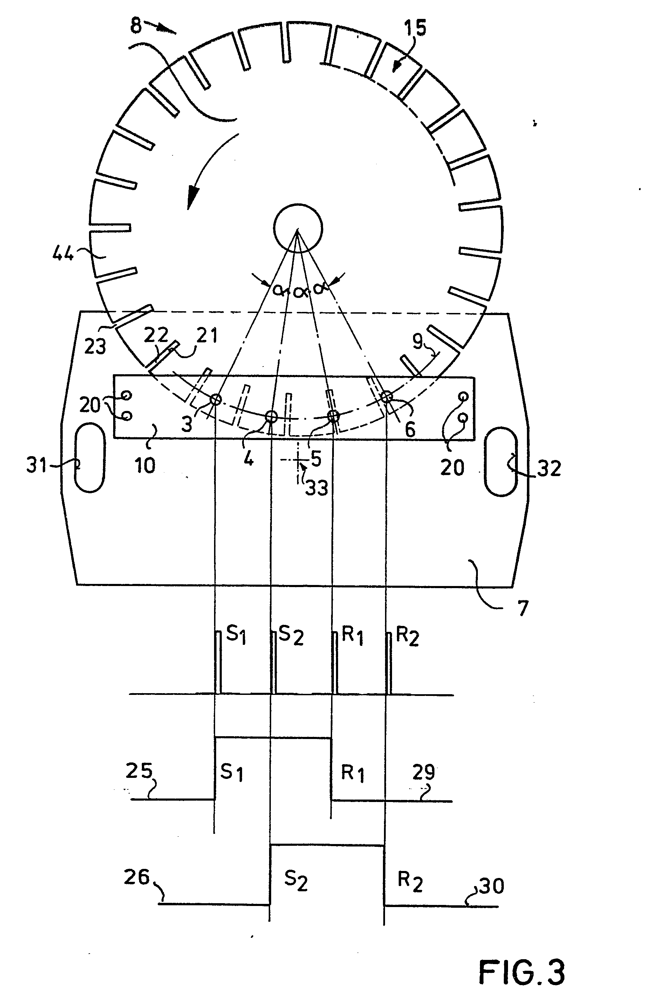

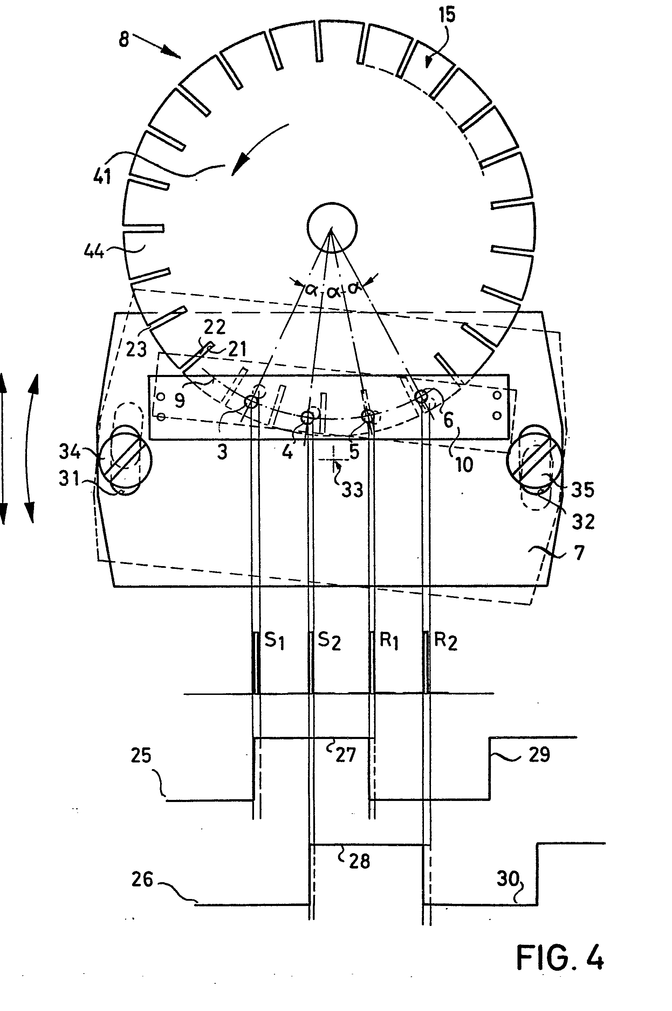

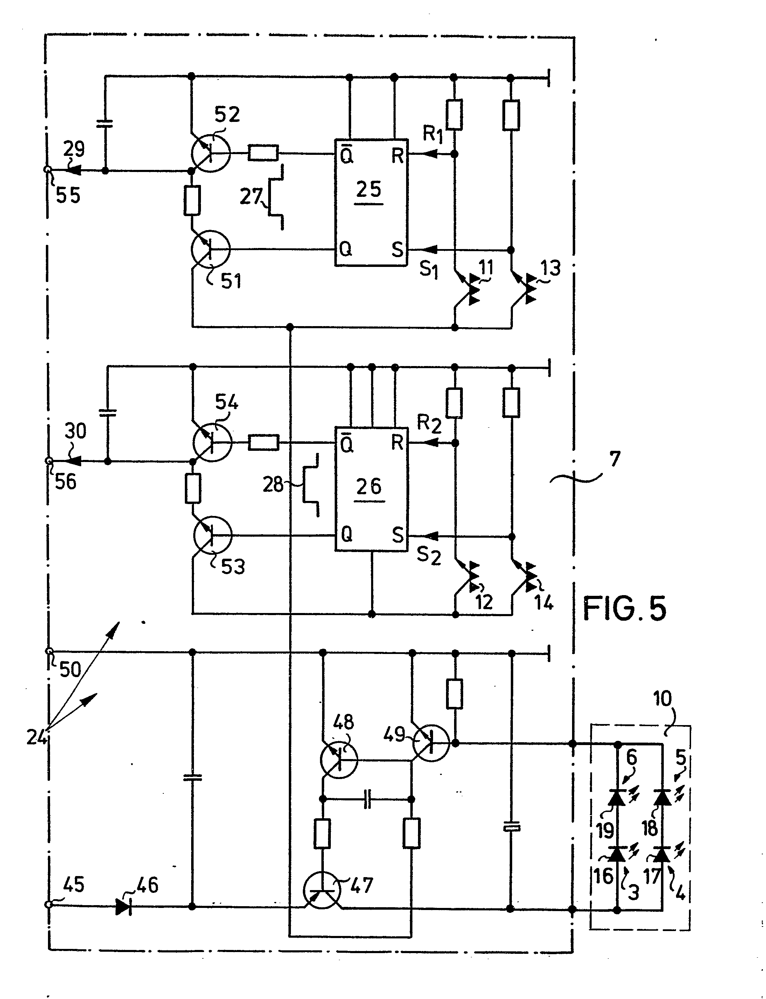

In der Darstellung nach FIG. 1 ist eine Ansicht eines vollständigen Impulsgebers bei abgenommenem Gehäusedeckel 2 gezeigt, wie er beispielsweise in Zapfsäulen benutzt wird zur Übertragung der von einem Meßwerk ermittelten Volumeneinheiten an ein Preisrechen- und Anzeigewerk. Das Impulsgebersystem ist in einem Gehäuse 1 untergebracht und besteht im wesentlichen aus vier getrennten Lichtschranken 3, 4, 5, 6, die auf einer Leiterplatte 7 angeordnet sind, und aus einer Schlitzscheibe 8 als Modulatorelement. Beim Aufbau der Lichtschranken 3, 4, 5, 6 werden handelsübliche, opto-elektronische Bauelemente eingesetzt, entsprechend verwendet man als Lichtquelle oder Sender beispielsweise Ga-As-Dioden 16 bis 19, als Empfänger auf der Gegenseite einen Fototransistor 11 bis 14, dem zur Verstärkung des Fotostromes weitere Transistoren in bekannter Schaltungsanordnung nachgeschaltet sein können, um ein geeignetes Steuersignal ausgangsseitig des Impulsgebers zu erzeugen. Die vier Dioden 16 bis 19 als Lichtquellen sind in einem Kreisbogen 9 auf einer Leiste 10 angeordnet, wobei der Radius des Kreisbogens 9 dem mittleren Radius einer Modulatorzone 15 auf der Schlitzscheibe 8 entspricht. Die Leiste 10 ist zur Stromversorgung der Dioden 16 bis 19 mit entsprechend angelegten Leiterbahnen versehen, die mit senkrecht in der Leiste 10 angeordneten Lötpins 20 verbunden sind. Die Leiste 10 ist mit den Lötpins 20 auf die Leiterplatte 7 aufsteckbar und wird mit einem bestimmten Abstand planparallel zur Leiterplatte 7 verlötet. Durch diese Anordnung gelangen die Dioden 16 bis 19 in eine Position, in welcher deren Lichtstrahl auf ebenfalls in einem entsprechenden Kreisbogen 9 auf der Leiterplatte 7 vorgesehene Fototransistoren 11 bis 14 trifft. Zur Erzeugung von Schaltimpulsen taucht die Schlitzscheibe 8 mit deren Modulatorzone 15 in den Bereich der Strahlengänge der vier Lichtschranken 3 bis 6 ein und verändert bei Drehung der Schlitzscheibe 8 im Takt der vorbeigeführten Zahnflanken 21, 22 der Schlitze 23 die auf den Fototransistor 11 bis 14 einfallende Lichtintensität. In Abhängigkeit der Form des Zahn-Lücken-Verhältnisses und der Drehzahl der Schlitzscheibe 8 wird der Lichteinfall auf den Detektor moduliert und im Fototransistor 11 bis 14 einer Lichtschranke 3 bis 6 ein entsprechender Schaltimpuls erzeugt. Aufgrund einer Anordnung von vier Lichtschranken 3 bis 6, die in einer Ausgangslage der Leiterplatte - bezogen auf den Mittelpunkt der Schlitzscheibe 8 einen bestimmten gleichen Drehwinkelabstand $\alpha$ zueinander aufweisen - ergeben sich in Abhängigkeit der Drehgeschwindigkeit der Schlitzscheibe 8 vier nacheinander zeitlich versetzte Schaltimpulse $S_1$, $S_2$, $R_1$, $R_2$ (FIG. 3). Der Abstand oder Versatz dieser vier Schaltimpulse $S_1$, $S_2$, $R_1$, $R_2$ zueinander ist gleich ausschließlich in der Einstell-lage der Leiterplatte 7 zu der Lage der Modulatorzone 15 der Schlitzscheibe 8, in der sich der Kreisbogen 9 in der Anordnung der Lichtschranken 3 bis 6 mit einem Kreisbogen 9 des mittleren Radius der Modulatorzone 15 überdeckt. Ordnet man den Schaltimpulsen $S_1$, $S_2$, $R_1$, $R_2$ der vier Lichtschranken 3 bis 6 durch Übertragung in eine gleichfalls auf der Leiterplatte 7 vorgesehene Schaltung 24 gemäß FIG. 5 eine Bedeutung zu, nach der beispielsweise die Schaltimpulse $S_1$, $S_2$, ausgehend von den Lichtschranken 3, 4, als so bezeichnete "Setz"-Schaltimpulse $S_1$, $S_2$ und die nachfolgenden Schaltim-pulse $R_1$, $R_2$ entsprechend als "Rücksetz"-Schaltimpulse $R_1$, $R_2$ an die Eingänge S, R zweier Flip-Flops 25, 26 gelegt sind, so entstehen an den Ausgängen Q und $\overline{Q}$ der Flip-Flops 25, 26 zwei voneinander um 90° versetzt angeordnete Rechtecksignale 27, 28. Die aus den Rechtecksignalen 27 und 28 in voneinander getrennten Impulsfolgen 29 am Ausgang des Flip-Flop 25 und einer Impulsfolge 30 ausgangsseitig des Flip-Flop 26 zur Verfügung stehenden Signale werden zur Auswertung, beispielsweise zur Bildung der Preisdaten, in einen elektronischen Rechner eingegeben. Gemäß einer amtlichen Forderung für eichfähige Geräte nach zweifacher Sicherheit für die Impulserzeugung sind bei dem nach FIG. 1 und 2 angezeigten Impulsgeber einschl. der Schaltung 24 zur Bildung definierter Rechtecksignale insgesamt vier Lichtschranken 3, 4, 5, 6 erforderlich. Da sowohl in der gegenseitigen, mechanischen Anordnung der Lichtschranken 3 bis 6 als auch in der technologischen Beschaffenheit Differenzen unvermeidbar sind, alle Lichtschranken 3, 4, 5, 6 jedoch mit derselben Schlitzscheibe 8 getaktet werden, erscheinen die Differenzen auch in der Erzeugung der Rechtecksignale 27, 28 in entsprechender Form. Über dies hinaus ist durch die feste Anordnung der Lichtschranken 3, 4, 5, 6 auf der Leiterplatte 7 eine gegenseitige Korrektur der Lage zwischen den einzelnen Lichtschranken 3, 4, 5, 6 nicht durchführbar. Um dennoch eine gegenseitige Abgleichung der Flanken der einzelnen Schaltimpulse $S_1$, $S_2$, $R_1$, $R_2$ zu erzielen, ist die Leiterplatte 7 mit den vier Lichtschranken 3, 4, 5, 6 als ein variabel in bezug auf die Modulatorzone 15 der Schlitzscheibe 8 positionierbares Teil ausgebildet, dergestalt daß durch eine Parallelverschiebung und Verdrehung der Lage der Leiterplatte 7 über die damit erzielbare Veränderung der Lage der Lichtschranken 3, 4, 5, 6 eine Abgleichung eines Impuls-Pause-Verhältnisses sowie ein gegenseitiger Versatz der beiden Impulsfolgen 29, 30 einstellbar ist. Um die Verstellbarkeit der Leiterplatte 7 zu erreichen, sind zur Ein- und Feststellung der Leiterplatte 7 in einer für die Lage der Schaltimpulse $S_1$, $S_2$, $R_1$, $R_2$ optimalen Position seitlich Langlöcher 31, 32 vorgesehen. Mit zwei Befestigungsschrauben 34, 35 wird die Einstellage der Leiterplatte 7 auf der Auflage im Gehäuse 1 fixiert. Aufgrund der Langlöcher 31, 32 in der Leiterplatte 7 läßt sich diese parallel verschieben und lagemäßig verdrehen. Es verändert sich damit die Lage der Winkelposition der Lichtschranken 3, 4, 5, 6 im Bereich der Modulatorzone 15. Wie an einem Beispiel gemäß FIG. 4 gezeigt ist, sind durch eine Verdrehung der Leiterplatte 7 und mithin der Lichtschranken 3, 4, 5, 6 um eine gedachte Achse 33 im Uhrzeigersinn Verschiebungen der Flanken der Rechtecksignale 27, 28 nach rechts einstellbar. Bezogen auf die angezeigte Drehrichtung der Schlitzscheibe 7 im Gegenuhrzeigersinn ist damit ein zeitverzögerter Versatz der Schaltimpulse $S_1$, $S_2$, $R_1$, $R_2$ und entsprechend der Rechtecksignale 27, 28 am Ausgang der Flip-Flops 25, 26 erzielbar.

Ganz allgemein entsteht durch Verschieben oder Drehen der Leiterplatte 7 mit den vier Lichtschranken 3, 4, 5, 6 eine andere Winkelposition der Lichtschranken 3, 4, 5, 6 zueinander. Davon abhängig verändern sich entsprechend die Abstände zwischen den Schaltimpulsen $S_1$, $S_2$, $R_1$, $R_2$, was zu einer Verschiebung der Ausgangssignale der Flip-Flops 25, 26 führt. Somit läßt sich das Impuls-Pause-Verhältnis und der Versatz des Rechtecksignals 1 zum Rechtecksignal 2 abgleichen. Über ein mehradriges Kabel 36 erfolgt die Spannungsversorgung der Schaltung 24 sowie die Überleitung der Impulsfolgen 29, 30 aus der Schaltung 24 an die auswertenden Einheiten.

Im Gehäuse 1 sowie dem Gehäusedeckel 2 sind Bohrungen 37, 38 für die Lagerung einer Welle 39 vorgesehen (FIG. 1 und 2), die die Schlitzscheibe 8 trägt. In dem im Durchmesser erweiterten Teil der Bohrung 37 ist verdrehfest ein Nadelfreilauf 40 eingelassen, der das Rückdrehen der Welle 39 gemäß dem Ausführungsbeispiel nach FIG. 1 im Uhrzeigersinn weitgehend verhindern soll. Über den Umfang der Schlitzscheibe 8 ist eine Modulatorzone 15 vorgesehen, die im wesentlichen aus einer vorgegebenen Anzahl in radialer Richtung auf eine bestimmte Tiefe in eine Scheibe 41 gefrästen Schlitzen 23 besteht. Die Scheibe 41 ist mit einer Buchse 42 vernietet und mittels Stift 43 verdrehfest mit der Welle 39 verbunden. Die lichtdurchlässigen Schlitze 23, die einen Schaltimpuls auslösen und auch verantwortlich sind für die Impulsform, sind relativ schmal ausgebildet im Vergleich zu der breiten, lichtundurchlässigen Form eines Zahnes 44, der aufgrund der Dunkelzone den gegenseitigen Abstand der Schaltimpulse $S_1$, $S_2$, $R_1$, $R_2$ voneinander bestimmt. Aus der Darstellung nach FIG. 4, in der die Leiterplatte 7 um eine gedachte, mittlere Achse 33 um einen Winkel verdreht ist, ist erkennbar, daß die Lichtschranke 3, die an den inneren Rand der Modulatorzone 15 gerückt ist, den größten Versatz des Schaltimpulses $S_1$ in Bewegungsrichtung der Schlitzscheibe 8 bewirkt. Den kleinsten Versatz in Bewegungsrichtung der Schlitzscheibe 8 erfährt der durch die letzte Lichtschranke 6 erzeugte Schaltimpuls $R_2$. Dreht man die Leiterplatte 7 aus der mittleren Ausgangslage gemäß FIG. 3 im Gegenuhrzeigersinn in eine entsprechende Winkelposition, so erzielt man ein davon abhängig umgekehrtes Ergebnis in bezug auf den Versatz der Schaltimpulse $S_1$, $S_2$, $R_1$, $R_2$. Der damit bewirkte Schaltimpuls $S_1$ an der Lichtschranke 3 weist einen geringeren, der Schaltimpuls $R_2$ einen entsprechend größeren Versatz vor den Schaltimpulsen $S_1$, $S_2$, $R_1$, $R_2$ aus der Mittellage der Leiterplatte nach FIG. 3 auf.

Bei nur Parallelverschiebung einwärts in die Modulatorzone 15 vergrößert sich der Winkelweg, entsprechend läßt sich der Versatz der Schaltimpulse $S_1$, $S_2$, $R_1$, $R_2$ verbreitern. Umgekehrt verkleinert sich der Winkelweg zwischen den Lichtschranken 3, 4, 5, 6 bei einer parallel verschobenen Einstellung der Leiterplatte 7 im peripheren Bereich der Modulatorzone 15. Die gegenseitige Lage der Schaltimpulse $S_1$, $S_2$, $R_1$, $R_2$ ist demnach durch Verdrehen und Parallelverschiebung der Leiterplatte 8 im Bereich der Modulatorzone 15 weitgehend einstellbar. Fehlerhafte Auswirkungen auf die Erzeugung der Schaltimpulse $S_1$, $S_2$, $R_1$, $R_2$ beispielsweise durch zu große Rücklauftoleranzen in dem Nadelfreilauf oder bedingt durch die unterschiedliche Lage der Lichtschranken 3, 4, 5, 6 und deren ungleiches elektrisches Schaltverhalten lassen sich damit durch eine geeignete Positionierung der Leiterplatte 7 im Bereich der Modulatorzone 15 ausschalten.

In FIG. 5 ist eine Ausbildungsform der Schaltung 24 zur Erzeugung und Umformung der Schaltimpulse $S_1$, $S_2$, $R_1$, $R_2$ der vier Lichtschranken 3, 4, 5, 6 in definierte Rechtecksignale 27, 28 gezeigt. Sämtliche Schaltungselemente sind auf der Leiterplatte 7 vorgesehen, mit Ausnahme der Dioden 16, 17, 18, 19, die in einigem Abstand von den Fototransistoren 11, 12, 13, 14 angebracht sein müssen und in dieser Eigenschaft auf der Leiste 1o mittels Lötpins 2o auf die Leiterplatte 7 aufsteckbar sind. Über einen Anschluß 45 und eine Verpolungsschutzdiode 46 ist eine Betriebsspannung an die Schaltung 24 gelegt und wird über einen Transistor 47 in eine Stabilisierungsschaltung, bestehend aus Transistoren 48, 49 geführt, die einen konstanten Strom für die Dioden 16, 17, 18, 19 der Lichtschranken 3, 4, 5, 6 gewährleisten. Ein stabilisierter Strom durch die Dioden 16, 17, 18, 19 wiederum ist eine Voraussetzung für einen konstanten, homogenen Lichtstrahlengang für die Lichtschranken 3, 4, 5, 6. Der negative Pol der Spannungsversorgung liegt an einem Anschluß 5o. Mittels der durch die Schlitzscheibe 8 unterbrochenen Lichtsignale entstehen in den Fototransistoren 13, 14, 11, 12 Schaltimpulse $S_1$, $S_2$, $R_1$, $R_2$, die entsprechend an die Eingänge S und R der beiden Flip-Flops 25 und 26 geführt sind. An den Ausgängen Q und $\overline{Q}$ der Flip-Flops 25, 26 entstehen die beiden Rechtecksignale 27 bzw. 28, die nochmals verstärkt durch Transistoren 51, 52 bzw. 53, 54 als Impulsfolge 29 bzw. 3o an Ausgänge 55 und 56 zur Weiterleitung beispielsweise an einen Rechner gelegt sind.

Die gesamte Schaltung 24 einschl. der Schlitzscheibe 8 als Modulatorelement ist nach den Vorschriften einer druckfesten Kapselung in das aus zwei Teilen bestehende Gehäuse 1 mit Gehäusedeckel 2 eingebaut. Der Antrieb der Schlitzscheibe 8 erfolgt über ein Zahnrad 57, das auf die außerhalb des Gehäuses 1 geführte Welle 39 verdrehfest aufgesetzt ist. Das Gehäuse 1 sowie der Gehäusedeckel 2, einschl. der Lagerung der Welle 39 im Gehäuse 1 sowie die Führung des mehradrigen Kabels 36 nach außerhalb des Gehäuses 1 sind nach den Vorschriften für eine druckfeste Kapselung ausgebildet, so daß der Impulsgeber auch die Anforderungen des angezeigten Ausführungsbeispiels zur Verwendung in explosionsgefährdeten Bereichen erfüllt.

27.02 0158066
o11.12 sche zw
Akte 1856

Patentansprüche:

1. Fotoelektrischer Impulsgeber zur Umsetzung digitaler Meßwerte in Form einer Drehbewegung in Impulse für die Verwendung in eichfähigen Geräten, wobei die Impulse durch die Bewegung einer Schlitzscheibe im Strahlengang einer Lichtschranke erzeugt werden,
dadurch gekennzeichnet,
daß in fester Anordnung auf einer Leiterplatte (7) vier Lichtschranken (3, 4, 5, 6) vorgesehen und die Lichtschranken (3, 4, 5, 6) auf einem Kreisbogen (9) mit dem mittleren Radius einer Modulatorzone (15) der Schlitzscheibe (8) in gleichen Drehwinkelabständen ($\alpha$) angeordnet sind,
daß die Leiterplatte (7) mit den vier Lichtschranken (3, 4, 5, 6) durch eine Parallelverschiebung und Verdrehung der Lage bezogen auf die Modulatorzone (15) einstellbar ist, dergestalt daß durch die Veränderbarkeit der Lage der Lichtschranken (3, 4, 5, 6) eine Abgleichung eines Impuls-Pause-Verhältnisses sowie ein gegenseitiger Versatz der beiden Impulsfolgen (29, 3o) einstellbar ist.

2. Fotoelektrischer Impulsgeber nach Anspruch 1,
dadurch gekennzeichnet,
daß die Lichtschranken (3, 4, 5, 6) aus je einem Lichtsender in Form einer Diode (16, 17, 18, 19) und einem Lichtempfänger in Form eines Fototransistors (11, 12, 13, 14) bestehen, wobei die Dioden (16, 17, 18, 19) auf einer in planparalleler Lage auf der Leiterplatte (7) aufsetzbaren Leiste (1o) vorgesehen sind und die Fototransistoren (11, 12, 13, 14) im Bereich des Lichtstrahlengangs der Dioden (16, 17, 18, 19) auf der Leiterplatte (7) integriert sind.

3. Fotoelektrischer Impulsgeber nach den Ansprüchen 1 und 2,
dadurch gekennzeichnet,
daß die Leiterplatte (7) eine Schaltung bestehend aus Transistoren (47, 48, 49) zur Stabilisierung des Stromes für die Dioden (16, 17, 18, 19) enthält.

4. Fotoelektrischer Impulsgeber nach den Ansprüchen 1 bis 3, gekennzeichnet durch eine Schaltungsanordnung (24) auf der Leiterplatte (7), mittels der die durch die Schlitzscheibe (8) getakteten Lichtimpulse von den Fototransistoren (11, 12, 13, 14) verstärkt unmittelbar an die Eingänge (S, R) zweier Flip-Flops (25, 26) geführt sind, wodurch an den Ausgängen (Q und $\overline{Q}$) der Flip-Flops (25, 26) Rechtecksignale (27, 28) entstehen.

5. Fotoelektrischer Impulsgeber nach Anspruch 4, dadurch gekennzeichnet, daß die Rechtecksignale (27, 28) an den beiden Flip-Flop-Ausgängen (Q und $\overline{Q}$) durch nachgeschaltete, auf der Leiterplatte (7) angeordnete Transistoren (51, 52 und 53, 54) verstärkt an den Ausgang (55, 56) des Impulsgebers gelegt sind.

6. Fotoelektrischer Impulsgeber nach den Ansprüchen 1 bis 5, dadurch gekennzeichnet, daß die bestückte Leiterplatte (7) mit den Lichtschranken (3, 4, 5, 6) als festes Bauteil in einem druckfesten, zweiteiligen Gehäuse (1, 2) integriert ist.

0158066

FIG.1

FIG. 2

0158066

FIG.3

0188066

FIG. 4

0158066

FIG.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| Y | DE-A-3 104 500 (HÜBNER ELEKTROMASCHINEN) * Seite 11, Zeilen 19-29; Figur 1 * | 1 | G 01 P 3/486 |
| Y | IBM TECHNICAL DISCLOSURE BULLETIN, Band 18, Nr. 12, Mai 1976, Seiten 3943-3944, New York, US; W.E. BROOM et al.: "Tachometer with phase adjustment features" * Das ganze Dokument; Figur * | 1 | |
| A | Idem | 2 | |
| A | DE-A-3 014 821 (MANNESMANN AG) * Seite 5, Zeilen 6-14; Figuren 3-5 * | 1 | **RECHERCHIERTE SACHGEBIETE (Int. Cl 4)** |
| A | DE-A-2 404 081 (LESTER et al.) * Seite 9, Zeilen 17-21; Figuren 1,3 * | 1 | G 01 P<br>G 01 F<br>H 03 M |
| A | EP-A-0 003 288 (ELECTRO-CRAFT CORP.) * Seite 9, Zeilen 8-30; Figuren 2,3,9 * | 1,2,4 | |
| | --- -/- | | |

Der vorliegende Recherchenbericht wurde für alle Patentansprüche erstellt.

| Recherchenort DEN HAAG | Abschlußdatum der Recherche 13-06-1985 | Prüfer HANSEN P. |
|---|---|---|

Europäisches
Patentamt

EUROPÄISCHER RECHERCHENBERICHT

Q158066
Nummer der Anmeldung

EP  85 10 1973

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-3 746 988  (E.H. FORD et al.) <br> * Spalte 3, Zeilen 11-13; Figur 2 * <br><br> --- | 3 | |
| A,D | US-A-3 436 655  (LUNDGREEN) <br> * Spalte 2, Zeilen 12-14; Figuren 1,3 * <br><br> --- | 4,5 | |
| A,D | DE-A-2 726 242  (KIENZLE APPARATE) <br> *  Seite 7, Zeilen 13-17; Figur 2 * <br><br> ----- | 6 | |

RECHERCHIERTE
SACHGEBIETE (Int. Cl.4)

Der vorliegende Recherchenbericht wurde für alle Patentansprüche erstellt.

| Recherchenort <br> DEN HAAG | Abschlußdatum der Recherche <br> 13-06-1985 | Prüfer <br> HANSEN P. |
|---|---|---|